(19) Europäisches Patentamt
European Patent Office
Office européen des brevets

(11) Veröffentlichungsnummer: **0 406 683 A2**

# (12) EUROPÄISCHE PATENTANMELDUNG

(21) Anmeldenummer: **90112228.3**

(51) Int. Cl.5: **G03F 7/027**

(22) Anmeldetag: **27.06.90**

(30) Priorität: **07.07.89 DE 3922330**

(43) Veröffentlichungstag der Anmeldung:
**09.01.91 Patentblatt 91/02**

(84) Benannte Vertragsstaaten:
**CH DE FR GB IT LI**

(71) Anmelder: **HOECHST AKTIENGESELLSCHAFT**
**Postfach 80 03 20**
**D-6230 Frankfurt am Main 80(DE)**

(72) Erfinder: **Gersdorf, Joachim, Dr.**
**Lohmühlweg 17**
**D-6200 Wiesbaden(DE)**
Erfinder: **Kleiner, Hans-Jerg, Dr.**
**Altkönigstrasse 11a**
**D-6242 Kronberg(DE)**

## (54) Durch Strahlung polymerisierbares Gemisch und dieses enthaltendes Aufzeichnungsmaterial.

(57) Es werden Ester von zweiwertigen Alkoholen mit Alkenylphosphon- oder -phosphinsäuren beschrieben, die radikalisch polymerisierbar sind. Sie werden zusammen mit polymeren Bindemitteln, insbesondere wasserlöslichen Polymeren, und radikalbildenden Photoinitiatoren zu photopolymerisierbaren Gemischen kombiniert, die zur Herstellung von Photoresists und Druckplatten geeignet sind. Die Gemische sind wenig temperaturempfindlich und gut lagerfähig.

EP 0 406 683 A2

# DURCH STRAHLUNG POLYMERISIERBARES GEMISCH UND DIESES ENTHALTENDES AUFZEICHNUNGSMATERIAL

Diese Erfindung betrifft ein durch Strahlung polymerisierbares Gemisch enthaltend ein polymeres Bindemittel, eine radikalisch polymerisierbare Verbindung und eine Verbindung, die unter Einwirkung aktinischer Strahlung die Polymerisation der polymerisierbaren Verbindung zu initiieren vermag, sowie ein Aufzeichnungsmaterial, enthaltend dieses strahlungsempfindliche Gemisch.

Photopolymerisierbare Gemische zur Herstellung von Druckplatten, Photoresists und anderen lichtempfindlichen Materialien enthalten radikalisch polymerisierbare Verbindungen, die bei Belichtung in Gegenwart eines Photoinitiators zu vernetzten, unlöslichen Produkten polymerisieren. Verbindungen dieser Art waren bisher fast ausschließlich Ester ungesättigter Carbonsäuren, insbesondere der Acryl- und Methacrylsäure, mit mehrwertigen aliphatischen oder cycloaliphatischen Alkoholen, die ggf. Urethan- oder Ethergruppen enthalten können. In älteren Druckschriften, z.B. in der US-A 2 892 716, werden auch Divinylester von aromatischen oder aliphatischen Disulfonsäuren als polymerisierbare Verbindungen erwähnt. Diese Verbindungen haben jedoch keinen Eingang in die Praxis gefunden.

Die bisher bevorzugten (Meth)acrylate mehrwertiger Alkohole haben, zumindest für einige Anwendungszwecke, bestimmte Nachteile. Sie sind bei höheren Temperaturen, z.B. oberhalb 150 °C, instabil, viele niedermolekulare Vertreter weisen eine hohe Flüchtigkeit auf, die sich bei längerer Lagerung in der Schicht und bei der Verarbeitung bei höheren Temperaturen bemerkbar macht. Außerdem sind die meisten bevorzugten Vertreter wasserunlöslich und dadurch schwerer mit wasserlöslichen oder hydrophilen Bindemitteln kombinierbar. Zudem verursachen die meisten (Meth)acrylate störende Hautreizungen.

Ester und andere Derivate von Alkenylphosphon- und -phosphinsäuren mit zumeist einwertigen Alkoholen sind bekannt und werden zur Herstellung von Polymeren, z.B. von Polyvinylphosphonsäure und ihren Derivaten, großtechnisch eingesetzt. Eine unmittelbare Verwertung der genannten ungesättigten Verbindungen - außer zur Herstellung von Polymeren - ist bisher nur in geringfügigem Umfang erfolgt, wobei man praktisch nur die Säureeigenschaften der Monomeren nutzte, ohne von der Polymerisationsfähigkeit der Alkenylgruppe Gebrauch zu machen. Das ist vermutlich auf die relativ geringe Polymerisationsneigung der bekannten Alkenylphosphonsäuren oder ihrer Derivate zurückzuführen (DE-B 11 06 963/11 35 176 = USA 3 297 663).

In der älteren deutschen Patentanmeldung P 38 17 424.8 werden dennoch strahlungshärtbare Gemische beschrieben, die als Monomere Alkenylphosphon- und -phosphinsäureester von 1,1,1-Tris-(hydroxymethyl)alkanen und von 2,2-Bis-hydroxymethyl-1,3-propandiol enthalten.

Aufgabe der Erfindung war es, ein durch Strahlung polymerisierbares Gemisch bereitzustellen, dessen Polymerisationsfähigkeit unter Bestrahlung in Gegenwart von strahlungsaktivierbaren Polymerisationsinitiatoren, insbesondere Photoinitiatoren, ähnlich gut wie die der bisher technisch genutzten Acryl- bzw. Methacrylsäureester ist und das polymerisierbare Verbindungen aufweist, die wasserlöslich, wenig flüchtig sowie weniger hautreizend sind.

Erfindungsgemäß wird ein durch Strahlung polymerisierbares Gemisch bereitgestellt, enthaltend als wesentliche Bestandteile

a) ein polymeres Bindemittel,

b) eine radikalisch polymerisierbare Verbindung und

c) ein Verbindung oder Verbindungskombination, die unter Einwirkung aktinischer Strahlung die Polymerisation der Verbindung b) zu initiieren vermag, dadurch gekennzeichnet, daß die radikalisch polymerisierbare Verbindung einen Alkenylphosphon- und/oder -phosphinsäureester der allgemeinen Formel I

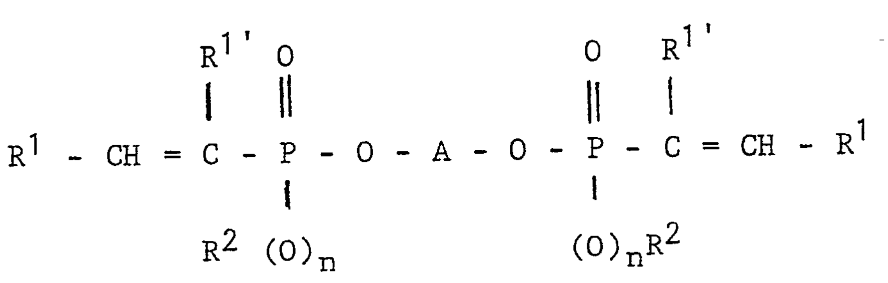

(I)

darstellt, worin

$R^1$ und $R^{1'}$ unabhängig voneinander Wasserstoff oder $(C_1$-$C_4)$-Alkyl,

$R^2$ $(C_1-C_4)$-Alkyl,
n 0 oder 1 und
A geradkettiges oder verzweigtes $(C_2-C_{12})$-Alkylen, oder eine Gruppe der Formel II

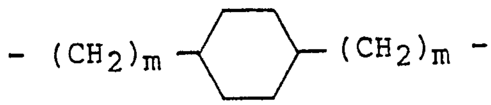 (II)

worin m 0 oder 1 ist,
oder eine Gruppe der Formel III

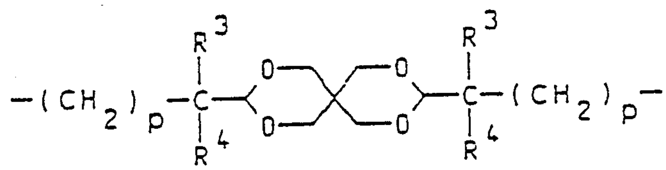 (III)

worin $R^3$ und $R^4$ unabhängig voneinander $(C_1-C_4)$Alkyl bedeuten und p 0 oder 1 ist
oder eine Gruppe der Formel IV
$-CH_2CH_2(OCH_2CH_2)_x-$ (IV)
worin x 1 bis 12 ist
oder eine Gruppe der Formel V
$-C_3H_6(OC_3H_6)_y$ (V)
worin y 1 bis 12 ist
oder eine Gruppe der Formel VI

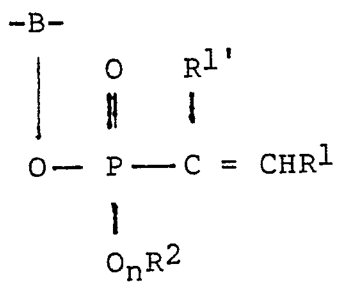 (VI)

worin B für geradkettiges oder verzweigtes $(C_3-C_{12})$-Alkylen steht und $R^1$, $R^{1'}$, $R^2$ und n wie oben angegeben definiert sind, bedeuten.

$R^1$ und $R^{1'}$ bedeuten bevorzugt Wasserstoff oder Methyl, insbesondere Wasserstoff,
$R^2$ bedeutet bevorzugt Methyl, Ethyl oder Propyl, insbesondere Methyl oder Ethyl.

Eine für A beziehungsweise für B stehende Alkylengruppe hat bevorzugt 3 bis 8 Kohlenstoffatome.

In der Gruppe der Formel III bedeuten $R^3$ und $R^4$ bevorzugt Methyl und Ethyl. In den Gruppen der Formeln IV und V steht x bzw. y bevorzugt für 1 bis 4.

A steht bevorzugt für Verbindungen der Formel II, in denen m gleich 0 oder für Verbindungen der Formel IV, in denen x gleich 1 bis 3, insbesondere 2 oder für Verbindungen der Formel V, in denen y gleich 1 bis 3, ins besondere 2 oder für Verbindungen der Formel VI, in denen B ein geradkettiges $(C_3-C_6)$-Alkylen, insbesondere $C_3$ oder $C_4$ Alkylen bedeuten.

A steht besonders bevorzugt für Propylen-1,3, Butylen-1,4, Hexylen-1,6, Hexylen-2,5, 2,2-Dimethylpropylen-1,3, Cyclohexylen-1,4, 2-Methyl-pentylen-2,4 sowie für die von Diethylenglykol, Triethylenglykol und Dipropylenglykol abgeleiteten Reste.

Die Verbindungen als solche sowie das Verfahren zu deren Herstellung werden in der deutschen Patentanmeldung P 39 22 327.2 beschrieben. Die Herstellung basiert auf der Umsetzung eines Alkenylphosphonsäureesterchlorids der allgemeinen Formel VII

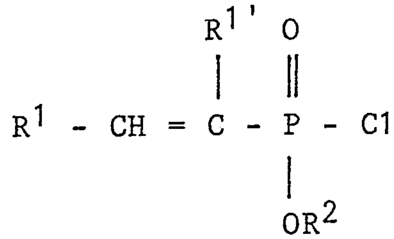

(VII)

oder eines Alkenylphosphinsäurechlorids der allgemeinen Formel VIII

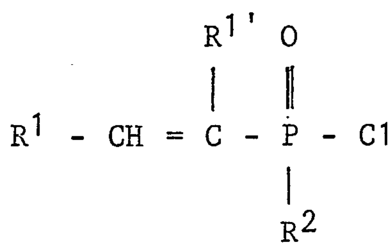

(VIII)

worin $R^1$, $R^{1'}$ und $R^2$ wie oben angegeben definiert sind, mit einem Alkohol der allgemeinen Formel IX
HO - A - OH (IX)
oder mit einem Alkohol der allgemeinen Formel X
HO - B - OH (X)
OH (an B)
worin A und B wie oben definiert sind.

Um bei der Reaktion freiwerdenden Chlorwasserstoff zu binden, werden bevorzugt geeignete tertiäre Amine als Säurefänger eingesetzt.

Geeignete tertiäre Amine sind beispielsweise Trialkylamine mit 1 bis 4 Kohlenstoffatomen pro Alkylrest, wie z.B. Triethylamin, Dialkylaniline mit 1 bis 4 Kohlenstoffatomen im Alkylrest, wie z.B. N,N′-Dimethylanilin und Pyridin.

Bevorzugterweise werden die Umsetzungen mit Molverhältnissen phosphororganische Verbindungen : Säurefänger : Alkohol der allgemeinen Formel IX von 2:2:1 beziehungsweise phosphororganische Verbindungen : Säurefänger : Alkohol der allgemeinen Formel X von 3:3:1 ausgeführt. Die Umsetzungen werden vorzugsweise unter Kühlung bei - 10 °C bis +40 °C in geeigneten inerten Lösungsmitteln ausgeführt.

Geeignete inerte Lösungsmittel sind beispielsweise halogenierte Kohlenwasserstoffe, wie z.B. Methylenchlorid, aromatische Kohlenwasserstoffe, wie z.B. Toluol, Ether, wie z.B. Tetrahydrofuran oder aliphatische Nitrile, wie z.B. Acetonitril.

Die bei den angegebenen Verfahren anfallenden Produkte können zum Teil durch Destillation, insbesondere mit Hilfe eines Dünnschichtverdampfers, im Hochvakuum gereinigt werden. Teilweise können sie aber auch direkt als Rohprodukt weiterverarbeitet werden.

Die Alkohole der allgemeinen Formeln IX und X sind bekannt und sind käuflich oder können nach bekannten Methoden hergestellt werden. Zweiwertige Alkohole der allgemeinen Formel IX sind beispielsweise Propandiol-1,3, Butandiol-1,4, Hexandiol-1,6, Hexandiol-2,5, 2,2-Dimethyl-1,3-propandiol, 2-Methyl-2,4-pentandiol, Cyclohexan-1,4-diol, Diethylenglykol, Triethylenglykol und Dipropylenglykol.

Dreiwertige Alkohole der allgemeinen Formel X sind beispielsweise Glycerin und Hexantriol-1,2,6.

Die phosphororganischen Verbindungen der allgemeinen Formeln VII und VIII sind käuflich oder nach gängigen Methoden zugänglich (z.B. Houben-Weyl, Methoden der Organischen Chemie, Georg Thieme Verlag, Stuttgart, Bd. 12/1, 1963, Seiten 217 ff und 338 ff).

Eine bevorzugte Verbindung der allgemeinen Formel VII ist Vinylphosphonsäureethylesterchlorid, eine solche der allgemeinen Formel VIII Methylvinylphosphinsäurechlorid.

Ein wesentlicher Vorteil der im erfindungsgemäß durch Strahlung polymerisierbaren Gemisch enthaltenen Verbindungen gemäß Formel I ist deren sehr gute Löslichkeit sowohl in polaren als auch in unpolaren Lösungsmitteln. So sind diese Monomeren im Gegensatz zu Trimethylolpropantriacrylat bzw. Trimethylolpropantrimethacrylat mit Wasser mischbar. Bei den genannten Monomeren handelt es sich um schwerflüchtige, geruchsarme Substanzen. Daraus resultiert auch die wesentlich geringere Neigung zur Diffusion oder Verdunstung aus photopolymerisierbaren Schichten. Zudem zeichnen sich diese Verbindungen durch eine

deutlich höhere Thermostabilität als die gebräuchlichen Acryl- und Methacrylsäureester aus.

Der Mengenanteil der durch Strahlung polymerisierbaren Schicht an den Monomeren gleich der allgemeinen Formel I beträgt im allgemeinen etwa 5 bis 80, vorzugsweise 8 bis 60 Gew.-%, bezogen auf die nichtflüchtigen Bestandteile der Schicht.

Als Bindemittel können in dem erfindungsgemäßen, durch Strahlung polymerisierbaren Gemisch eine Vielzahl löslicher organischer Polymeren Einsatz finden. Als Beispiele seien genannt: Polyamide, Polyvinylester, Polyvinylacetale, Epoxidharze, Polyacrylsäureester, Polymethacrylsäureester, Polyester, Alkydharze, Polybutadien, Polyisopren, Isopren-Styrol-Blockcopolymere und andere Elastomere, sowie Mischpolymerisate der Monomeren, die die aufgezählten Homopolymerisate bilden.

Ebenso können Bindemittel Verwendung finden, die wasserunlöslich, aber in wäßrig-alkalischen Lösungen löslich oder mindestens quellbar sind, da sich Schichten mit solchen Bindemitteln mit wäßrig-alkalischen Entwicklern entwickeln lassen. Derartige Bindemittel können z.B. die folgenden Gruppen enthalten: -COOH, $PO_3H_2$, $-SO_2NH-$; $-SO_2NH-$; $-SO_2-NH-SO_2-$ und $-SO_2-NH-CO-$.

Als Beispiele hierfür seien genannt: Maleinatharze, Polymerisate aus N-(p-Tolyl-sulfonyl)-carbaminsäure-ß-(methacryloyloxy)-ethylester und Mischpolymerisate dieser und ähnlicher Monomerer mit anderen Monomeren, Vinylacetat/Crotonsäure-, Styrol/Maleinsäureanhydrid-, Alkylmethacrylat/Methacrylsäure, höheren Alkylmethacrylaten und Methylmethacrylat und/oder Styrol oder Acrylnitril.

Mit besonderem Vorteil werden Gemische auf Basis wasserlöslicher Bindemittel eingesetzt, da sich die er findungsgemäßen wasserlöslichen polymerisierbaren Verbindungen mit diesen besonders leicht kombinieren lassen und eine bequeme und umweltfreundliche Beschichtung aus wäßriger Lösung erlauben. Beispiele für solche Bindemittel sind Polyvinylalkohol, teilverseifte Polyvinylacetale und Vinylaceta-Mischpolymerisate, Polyvinylether, Polyvinylpyrrolidon, Polyacrylamid, Polydimethylacrylamid, Polyethylenoxid, Polyvinylmethylformamid, Polyvinylmethylacetamid sowie wasserlösliche natürliche Polymere.

Die Menge des Bindemittels beträgt im allgemeinen 20 bis 95, vorzugsweise 40 bis 90 Gew.-%, bezogen auf die nichtflüchtigen Bestandteile der Schicht.

Das erfindungsgemäße, durch Strahlung polymerisierbare Gemisch kann je nach geplanter Anwendung und je nach den gewünschten Eigenschaften verschiedenartige Stoffe als Zusätze enthalten. Beispiele sind: Polymerisationsinhibitoren, Wasserstoffdonatoren, Farbstoffe, gefärbte und ungefärbte Pigmente und Weichmacher.

Als aktinische Strahlung soll im Rahmen dieser Beschreibung jede Strahlung verstanden werden, deren Energie mindestens der des sichtbaren Lichts entspricht. Geeignet ist u.a. sichtbares Licht, langwellige und kurzwellige UV-Strahlung, Laserstrahlung, Elektronen- und Röntgenstrahlung.

Als Photoinitiatoren in dem erfindungsgemäßen Gemisch können eine Vielzahl von Substanzen Verwendung finden. Beispiele sind solche, die sich vom Grundkörper der Benzophenone, Acetophenone, Benzoine, Benzile, Benzilmonoketale, des Fluorenons, Thioxanthons, der Mehrkernchinone, Acridine und Chinoxaline ableiten; ferner Trichlormethyl-s-triazine, 2-Halogenmethylgruppen substituierte Halogenoxazole, Trihalogenmethylgruppen enthaltende Carbonylmethylenheterocyclen gemäß DE-A 33 33 450 oder Acylphosphinoxidverbindungen, wie sie z. B. in der DE-A 31 33 419 beschrieben sind.

Die Initiatoren werden allgemein in einer Menge von 0,01 bis 10, vorzugsweise von 0,05 bis 4 Gew.-%, bezogen auf die nichtflüchtigen Bestandteile des Gemischs, eingesetzt.

Wenn die Bebilderung mit Röntgen- oder Elektronenstrahlen durchgeführt wird, sind neben den bekannten für sichtbares und nahes UV-Licht empfindlichen Photoinitiatoren auch solche geeignet, deren Absorptionsbereiche im kurzwelligen Teil des elektromagnetischen Spektrums liegen und die damit gegenüber Tageslicht wenig empfindlich sind. Dies hat den Vorteil, daß man die Aufzeichnungsmaterialien ohne Lichtausschluß handhaben kann und daß man die Materialien besser lagerfähig machen kann. Als Beispiele für derartige Starter sind Tribrommethyl-phenylsulfon, 2,2′,4,4′,6,6′-Hexabromdiphenylamin, Pentabromethan, 2,3,4,5-Tetrachloranilin, Pentaerythrittetrabromid, Chlorterphenylharze oder chlorierte Paraffine zu nennen.

Das photopolymerisierbare Gemisch kann für die verschiedensten Anwendungen Einsatz finden, beispielsweise zur Herstellung von Lacken, die durch Licht gehärtet werden, als Zahnfüll- oder -ersatzmaterial und insbesondere als lichtempfindliches Aufzeichnungsmaterial auf dem Reproduktionsgebiet. Die detaillierte Beschreibung der Erfindung beschränkt sich auf dieses Anwendungsgebiet, jedoch ist die Erfindung nicht hierauf beschränkt.

Als Anwendungsmöglichkeiten auf dem Reproduktionsgebiet seien genannt: Aufzeichnungsschichten für die photomechanische Herstellung von Druckformen für den Hochdruck, besonders Flexodruck, den Flachdruck, den Tiefdruck, den Siebdruck, von Reliefkopien, z.B. Herstellung von Texten in Blindenschrift, von Einzelkopien, Gerbbildern, Pigmentbildern usw.. Weiter sind die Gemische zur photomechanischen

Herstellung von Ätzreservagen, z.B. für die Fertigung von Namensschildern, von kopierten Schaltungen und für das Formteilätzen, anwendbar. Besondere Bedeutung haben die erfindungsgemäßen Gemische als Kopierschichten für die photomechanische Herstellung von Druckformen und für die Photoresisttechnik.

Die gewerbliche Verwertung des erfindungsgemäßen Gemischs für die genannten Anwendungszwecke kann in der Form einer flüssigen Lösung oder Dispersion, z. B. als Photoresistlösung, erfolgen, die z. B. zum Formteilätzen, für die Herstellung kopierter Schaltungen oder Siebdruckschablonen und dgl., aufgebracht wird. Das erfindungsgemäße Gemisch kann auch als feste lichtempfindliche Schicht auf einem geeigneten Träger in Form eines lagerfähig vorbeschichteten lichtempfindlichen Kopiermaterials, z. B. für die Herstellung von Druckformen, vorliegen. Ebenso ist es für die Herstellung von Trockenresist geeignet.

Erfindungsgemäß wird daher weiterhin ein durch Strahlung polymerisierbares Aufzeichnungsmaterial vorgeschlagen, enthaltend ein auf einem Träger aufgebrachtes durch Strahlung polymerisierbares Gemisch gemäß den obengenannten Ausführungen.

Es ist im allgemeinen günstig, das erfindungsgemäße Aufzeichnungsmaterial während der bildmäßigen Bestrahlung dem Einfluß des Luftsauerstoffs weitgehend zu entziehen. Im Fall der Anwendung in Form sehr dünner Aufzeichnungsschichten ist es empfehlenswert, einen geeigneten, für Sauerstoff wenig durchlässigen Deckfilm auf die strahlungsempfindliche Schicht aufzubringen, der mechanisch abziehbar oder entwicklerlöslich sein kann.

Als Schichtträger des erfindungsgemäßen Aufzeichnungsmaterials sind beispielsweise Aluminium, Stahl, Zink, Kupfer und Kunststoff-Folien, z. B. aus Polyethylenterephthalat oder Celluloseacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen bzw. das Reflexionsvermögen des Trägers im aktinischen Bereich der Kopierschicht herabzusetzen (Lichthofschutz).

Die Herstellung der durch Strahlung photopolymerisierbaren Aufzeichnungsmaterialien unter Verwendung des erfindungsgemäßen Gemischs erfolgt in bekannter Weise. So kann man dieses in einem Lösemittel aufnehmen und die Lösung bzw. Dispersion durch Gießen, Sprühen, Tauchen, Antrag mit Walzen usw. auf den vorgesehenen Träger aufbringen und anschließend trocknen. Dicke Schichten (z. B. von 250 µm und darüber) werden vorteilhaft durch Extrudieren oder Verpressen als selbsttragende Folie hergestellt, welche dann ggf. auf einen Träger laminiert wird. Im Falle von Trockenresist werden Lösungen des Gemischs auf transparente Träger aufgebracht und getrocknet. Die lichtempfindlichen Schichten - Dicke etwa zwischen 10 und 100µm - werden dann gleichfalls zunächst zusammen mit dem temporären Träger auf das gewünschte Substrat auflaminiert.

Die Verarbeitung der strahlungsempfindlichen polymerisierbaren Aufzeichnungsmaterialien wird in bekannter Weise vorgenommen. Zur besseren Vernetzung der strahlungsempfindlichen Schicht kann eine Nacherwärmung nach dem Bestrahlen erfolgen. Zur Entwicklung wird sie mit einer geeigneten Entwicklerflüssigkeit, z. B. mit organischen Lösemitteln, mit schwach alkalischen wäßrigen Lösungen oder vorteilhaft mit Wasser allein, behandelt, wobei die unbestrahlten Anteile der Schicht entfernt werden und die belichteten Bereiche der Kopierschicht auf dem Träger zurückbleiben.

Im folgenden werden Herstellungs- und Ausführungsbeispiele für die Erfindung angegeben. Darin sind Prozent-und Mengenverhältnisse, wenn nichts anderes angegeben ist, in Gewichtseinheiten zu verstehen. Die im erfindungsgemäßen, durch Strahlung polymerisierbaren Gemisch enthaltenden Monomeren gemäß Formel I sind in Tabelle I angegeben.

## Herstellungsbeispiel 1

Umsetzung von Methyl-vinylphosphinsäurechlorid mit Butandiol-1,4

36 g (0,4 mol) Butandiol-1,4 wurden zusammen mit 81 g (0,8 mol) Triethylamin in 270 ml Toluol gegeben. Unter lebhaftem Rühren wurden 99,6 g (0,8 mol) Methyl-vinylphosphinsäurechlorid unter Kühlung bei 20 - 25° C zugetropft. Dann wurde 20 Stunden nachgerührt und anschließend das gebildete Triethylaminhydrochlorid abgesaugt. Es wurde mit Toluol gewaschen und das Filtrat durch Destillation im Vakuum vom Toluol befreit. Der Rückstand wurde bei 0,093 kPa und einer Badtemperatur von 190° C über einen Dünnschichtverdampfer destilliert. Man erhielt 92 g, $n_D^{20}$ : 1,4805. Die Ausbeute betrug 87 % d.Th.

| $C_{10}H_{20}O_4P_2$ (266) | | | |
|---|---|---|---|
| ber.: | 45,11 % C | 7,52 % H | 23,31 % P |
| gef.: | 45,1 % C | 7,4 % H | 22,9 % P |

Herstellungsbeispiel 2

Umsetzung von Methyl-vinylphosphinsäurechlorid mit Hexandiol-1,6

59,1 g (0,5 mol) Hexandiol-1,6 wurden zusammen mit 101 g (1 mol) Triethylamin in 200 ml Toluol gegeben. Unter lebhaftem Rühren wurden 124,5 g (1 mol) Methyl-vinylphosphinsäurechlorid unter Kühlung bei 20° C zugetropft. Dann wurde 18 Stunden nachgerührt und anschließend das gebildete Triethylaminhydrochlorid abgesaugt. Es wurde mit Toluol gewaschen und das Filtrat durch Destillation im Vakuum vom Toluol befreit. Der Rückstand wurde bei 0,067 kPa und einer Badtemperatur von 205° C über einen Dünnschichtverdampfer destilliert. Man erhielt 135 g, $n_D^{20}$ : 1,4819. Die Ausbeute betrug

| $C_{12}H_{24}O_4P_2$ (294) | | | |
|---|---|---|---|
| ber.: | 48,98 % C | 8,16 % H | 21,09 % P |
| gef.: | 48,9 % C | 8,3 % H | 21,0 % P |

Herstellungsbeispiel 3

Umsetzung von Methyl-vinylphosphinsäurechlorid mit Hexandiol-2,,5

59,1 g (0,5 mol) Hexandiol-2,5 wurden zusammen mit 101 g (1 mol) Triethylamin in 200 ml Toluol gegeben. Unter lebhaftem Rühren wurden 124,5 g (1 mol) Methylvinylphosphinsäurechlorid unter Kühlung bei 20° C zugetropft. Dann wurde 18 Stunden nachgerührt und anschließend das gebildete Triethylaminhydrochlorid abgesaugt. Es wurde mit Toluol gewaschen und das Filtrat durch Destillation im Vakuum vom Toluol befreit. Der Rückstand wurde bei 0,2 kPa und einer Badtemperatur von 200° C über einen Dünnschichtverdampfer destilliert. Man erhielt 130 g. Das anfallende Produkt hatte die Säurezahl 44. Es stellte ein Rohprodukt dar. Die Ausbeute betrug 92 % d.Th.

$C_{12}H_{24}O_4P_2$ (294)

Herstellungsbeispiel 4

Umsetzung von Methyl-vinylphosphinsäurechlorid mit 2,2-Dimethyl-propandiol-1,3

15,6 g (0,15 mol) 2,2-Dimethylpropandiol-1,3 wurden zusammen mit 30,4 g (0,3 mol) Triethylamin in 75 ml Toluol gegeben. Unter lebhaftem Rühren wurden 37,35 g (0,3 mol) Methyl-vinylphosphinsäurechlorid unter Kühlung bei 20 - 25° C zugetropft. Dann wurde nachgerührt und anschließend das gebildete Triethylaminhydrochlorid abgesaugt. Es wurde mit Toluol gewaschen und das Filtrat im Vakuum vom Toluol befreit. Es verblieben 40 g. Das anfallende Produkt hatte die Säurezahl 49. Es stellte ein Rohprodukt dar. Die Ausbeute betrug 97 % d.Th.

$C_{11}H_{16}O_4P_2$ (274)

Herstellungsbeispiel 5

Umsetzung von Methyl-vinylphosphinsäurechlorid mit Cyclohexandiol-1,4

23,2 g (0,2 mol) Cyclohexandiol-1,4 wurden zusammen mit 40,5 g (0,4 mol) Triethylamin in 90 ml Toluol gegeben. Unter lebhaftem Rühren wurden 49,8 g (0,4 mol) Methylvinylphosphinsäurechlorid unter Kühlung bei 20° C zugetropft. Nach dem Nachrühren wurde das gebildete Triethylaminhydrochlorid abgesaugt. Es wurde mit Toluol gewaschen und das Filtrat durch Destillation im Vakuum vom Toluol befreit. Der Rückstand kristallisierte. Durch Digerierern mit Ethylmethylketon wurde das Produkt gewonnen. Schmelzpunkt:

| $C_{12}H_{22}O_4P_2$ (292) | | | |
|---|---|---|---|
| ber.: | 49,32 % C | 7,53 % H | 21,23 % P |
| gef.: | 48,52 % C | 8,02 % H | 21,0 % P |

Herstellungsbeispiel 6

Umsetzung von Methyl-vinylphosphinsäurechlorid mit Triethylenglykol

37,6 g (0,25 mol) Triethylenglykol wurden zusammen mit 50,6 g (0,5 mol) Triethylamin in 100 ml Toluol gegeben. Unter lebhaftem Rühren wurden 62,25 g (0,5 mol) Methyl-vinylphosphinsäurechlorid unter Kühlung bei 20° C zugetropft. Nach dem Nachrühren wurde das gebildete Triethylaminhydrochlorid abgesaugt. Es wurde mit Toluol gewaschen und das Filtrat durch Destillation im Vakuum vom Toluol befreit. Der Rückstand wurde bei 0,027 kPa und einer Badtemperatur von 240 - 245° C über einen Dünnschichtverdampfer destilliert. Man erhielt 65 g, $n_D^{20}$ : 1,4843. Die Ausbeute betrug

| $C_{12}H_{24}O_6P_2$ (326) | | | |
|---|---|---|---|
| ber.: | 44,17 % C | 7,36 % H | 19,02 % P |
| gef.: | 44,4 % C | 7,4 % H | 18,8 % P |

Herstellungsbeispiel 7

Umsetzung von Methyl-vinylphosphinsäurechlorid mit Dipropylenglykol (Isomerengemisch)

33,6 g (0,25 mol) Dipropylenglykol (Isomerengemisch) wurden zusammen mit 50,6 g (0,5 mol) Triethylamin in 100 ml Toluol gegeben. Unter lebhaftem Rühren wurden 62,25 g (0,5 mol) Methylvinylphosphinsäurechlorid unter Kühlung bei 20° C während 1,5 Std. eingetropft. 18 Std. wurde nachgerührt. Dann wurde das gebildete Triethylaminhydrochlorid abgesaugt. Es wurde mit Toluol gewaschen und das Filtrat durch Destillation im Vakuum vom Toluol befreit. Man erhielt 77,5 g als Rohprodukt $n_D^{20}$ : 1,4768.

Eine Reinigung durch Destillation mit Hilfe eines Dünnschichtverdampfers bei einer Badtemperatur von ca. 220° C und 0,027 kPa war möglich.

| $C_{12}H_{24}O_5P_2$ (310) | | | |
|---|---|---|---|
| ber.: | 46,45 % C | 7,74 % H | 20,00 % P |
| gef.: | 46,4 % C | 7,7 % H | 19,8 % P |

Herstellungsbeispiel 8

Umsetzung von Vinylphosphonsäureethylesterchlorid mit Hexandiol-1,6

28,6 g (0,242 mol) Hexandiol-1,6 wurden zusammen mit 49 g (0,484 mol) Triethylamin in 100 ml Toluol gegeben. Unter lebhaftem Rühren wurden 74,9 g (0,484 mol) Vinylphosphonsäureethylesterchlorid unter Kühlung bei 20° C zugetropft. Nach dem Nachrühren wurde das gebildete Triethylaminhydrochlorid abgesaugt. Es wurde mit Toluol gewaschen und das Filtrat durch Destillation im Vakuum vom Toluol befreit. Man erhielt 84 g. Eine destillative Reinigung mit Hilfe eines Dünnschichtverdampfers bei einer Badtemperatur von 250 - 260° C und 0,04 kPa war möglich, $n_D^{20}$ : 1,4623. Die Ausbeute betrug

| $C_{14}H_{28}O_6P_2$ (354) | | | |
|---|---|---|---|
| ber.: | 47,46 % C | 7,91 % H | 17,51 % P |
| gef.: | 47,4 % C | 7,8 % H | 17,4 % P |

Herstellungsbeispiel 9

Umsetzung von Methyl-vinylphosphinsäurechlorid mit Glycerin

9,2 g (0,1 mol) Glycerin wurden zusammen mit 30,4 g (0,3 mol) Triethylamin in 70 ml Acetonitril gegeben. Unter lebhaftem Rühren wurden 37,4 g (0,3 mol) Methylvinylphosphinsäurechlorid während 45 Minuten unter Kühlung bei 20 - 25° C eingetropft. Dann wurde 20 Stunden nachgerührt und anschließend das gebildete Triethylaminhydrochlorid abgesaugt. Es wurde mit eiskaltem Acetonitril gewaschen und das Filtrat durch Destillation im Vakuum vom Acetonitril befreit. Man erhielt 43,5 g, die erneut über eine Fritte gesaugt wurden, um Restmengen an Triethylaminhydrochlorid abzutrennen. Das Filtrat stellte das Rohprodukt dar. Es wies eine Säurezahl von 140 auf.

$n_D^{20}$ : 1,4802.

Es konnte bei einer Badtemperatur von 240° C und 0,107 kPa über einen Dünnschichtverdampfer destilliert werden.

$C_{12}H_{23}O_6P_3$ (356)

Tabelle I (Verbindungen gemäß der allgemeinen Formel I)

| Herstellungs-beispiel | $R^1$ | $R^{1'}$ | $R^2$ | n | A |
|---|---|---|---|---|---|
| 1 | H | H | $CH_3$ | 0 | $-CH_2(CH_2)_2CH_2-$ |
| 2 | H | H | $CH_3$ | 0 | $-CH_2(CH_2)_4CH_2-$ |
| 3 | H | H | $CH_3$ | 0 | 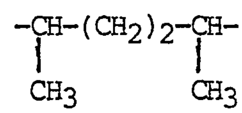 |
| 4 | H | H | $CH_3$ | 0 | 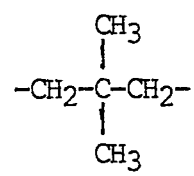 |
| 5 | H | H | $CH_3$ | 0 | 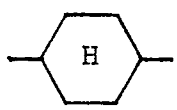 |
| 6 | H | H | $CH_3$ | 0 | $-CH_2CH_2-O-CH_2CH_2-O-CH_2CH_2-$ |
| 7 | H | H | $CH_3$ | 0 | $-C_3H_6-O-C_3H_6-$ (Isomerengemisch) |
| 8 | H | H | $C_2H_5$ | 1 | $-CH_2(CH_2)_4CH_2-$ |
| 9 | H | H | $CH_3$ | 0 | 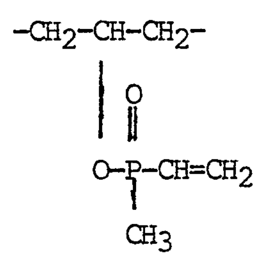 |

Anwendungsbeispiel 1

145,5 g eines innerlich weichgemachten Vinylalkohol-Copolymeren mit einer Viskosität von 4 mPas in 4 %iger wäßriger Lösung bei 20° C und der Esterzahl 150 wurden durch Rühren in 147 g Wasser bei 90° C gelöst. Nach Abkühlen auf 70° C wurden unter Rühren 100 g der Verbindung aus Herstellungsbeispiel 1, 5 g Benzildimethylketal und 1 g 2;6-Di-tert.butyl-4-methylphenol zugegeben. Die homogene Lösung wurde auf eine 0,125 mm dicke Polyethylenterephthalatfolie schichtförmig so aufgetragen, daß nach 48-stündigem

Trocknen bei Raumtemperatur eine ca. 1 mm dicke, nicht klebende lichtempfindliche Schicht resultierte. Auf die freie Schichtoberfläche wurde ein mit einem Polyurethan-Haftlack gemäß DE-A 15 97 515 versehenes 0,3 mm dickes Aluminiumblech aufgelegt und das Mehrschichtelement in einer Plattenpresse bei 100° C zwei Minuten gepreßt. Der Haftlack wurde durch Umsetzen eines verzweigten Polyesters aus Adipinsäure, Glycerin und Butylenglykol mit 5,2 % OH-Gruppengehalt mit Triphenylmethan-4,4',4''-triisocyanat erhalten. Die Dicke der Distanzstücke wurde so gewählt, daß nach dem Heißpressen eine 0,6 mm dicke Photopolymerschicht erhalten wurde. Nach dem Abziehen der Polyesterfolie wurde die lichtempfindliche Schicht bildmäßig 20 Minuten mit einem handelsüblichen UVA-Flachbelichter (Emissionswellenlängenbereich 320 bis 400 nm, Intensität 10 mW/cm$^2$) belichtet. Nach dem Auswaschen der nichtbelichteten Bildstellen mit warmem Wasser wurde eine Hochdruckform mit guter Reliefausbildung und einer Härte von 75 Shore-A erhalten.

Anwendungsbeispiel 2

Die Herstellung der Photopolymerschicht und anschließende Verarbeitung zu einer Hochdruckplatte erfolgte analog Anwendungsbeispiel 1, nur diesmal wurden allerdings 100 g der Verbindung aus Herstellungsbeispiel 2 als vernetzbares Monomeres eingesetzt. Es wurde eine Hochdruckplatte mit guter Reliefausbildung und einer Härte von 79 Shore-A erhalten.

Anwendungsbeispiel 3

Die Herstellung der Photopolymerschicht und anschließende Verarbeitung zu einer Hochdruckplatte erfolgte analog Anwendungsbeispiel 1, diesmal wurden allerdings 100 g der Verbindung aus Herstellungsbeispiel 6 als vernetzbares Monomeres eingesetzt. Es wurde eine Hochdruckplatte mit guter Reliefausbildung und einer Härte von 98 Shore-A erhalten.

Anwendungsbeispiel 4

Die Herstellung der Photopolymerschicht und anschließende Verarbeitung zu einer Hochdruckplatte erfolgte analog Anwendungsbeispiel 1, diesmal wurden allerdings 100 g der Verbindung aus Herstellungsbeispiel 7 als vernetzbares Monomeres eingesetzt, die Belichtungszeit betrug 15 Minuten. Es wurde eine Hochdruckplatte mit guter Reliefausbildung und einer Härte von 98 Shore-A erhalten.

Anwendungsbeispiel 5

144,4 g eines teilverseiften Vinylacetat-Pfropfpolymeren (43,8 % Vinylalkohol, 13,8 g Vinylacetat und 42,8 % Pfropfgrundlage) mit Polyurethan-Pfropfgrundlage (Polyurethan aus 3.000 g Polyethylenglykol-600, 193,1 g 1,4-Butandiol und 1.428,2 g Isophorondiisocyanat) wurden zusammen mit einer Mischung aus 50 g der Verbindung aus Herstellungsbeispiel 8, 4 g Benzildimethylketal und 0,8 g 2,6-Di-tert.butyl-4-methylphenol bei 160° C extrudiert und anschließend zwischen einer 0,125 µm dicken Polyethylenterephthalatfolie und einem wie in Beispiel 1 beschriebenen vorbehandelten Aluminiumblech bei 130° C und 35 bar heißgepreßt. Die Weiterverarbeitung des Mehrschichtenelements erfolgte wie in Beispiel 1 beschrieben. Es wurde eine Hochdruckform mit guter Reliefausbildung und einer Härte von 76 Shore-A erhalten.

## Ansprüche

1. Durch Strahlung polymerisierbares Gemisch, enthaltend als wesentliche Bestandteile
a) ein polymeres Bindemittel,
b) eine radikalisch polymerisierbare Verbindung und
c) eine Verbindung oder Verbindungskombination, die unter Einwirkung aktinischer Strahlung die Polymerisation der Verbindung b) zu initiieren vermag,
dadurch gekennzeichnet, daß die radikalisch polymerisierbare Verbindung einen Alkenylphosphon- und/oder -phosphinsäureester der allgemeinen Formel I

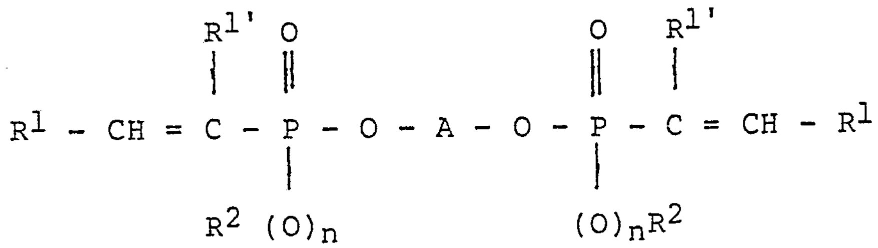 (I)

darstellt, worin
$R^1$ und $R^{1'}$ unabhängig voneinander Wasserstoff oder $(C_1\text{-}C_4)$-Alkyl,
$R^2$ $(C_1\text{-}C_4)$-Alkyl,
n 0 oder 1 und
A geradkettiges oder verzweigtes $(C_2\text{-}C_{12})$-Alkylen, oder eine Gruppe der Formel II

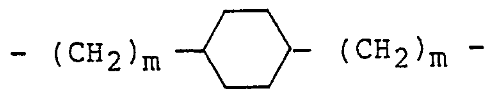 (II)

worin m 0 oder 1 ist,
oder eine Gruppe der Formel III

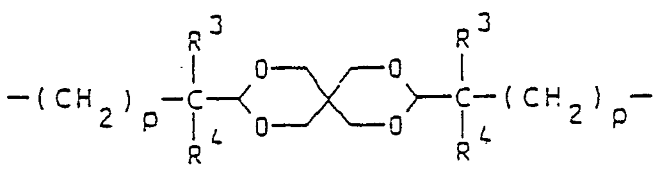 (III)

worin $R^3$ und $R^4$ unabhängig voneinander $(C_1\text{-}C_4)$Alkyl bedeuten und p 0 oder 1 ist
oder eine Gruppe der Formel IV
$-CH_2CH_2(OCH_2CH_2)_x-$ (IV)
worin x 1 bis 12 ist
oder eine Gruppe der Formel V
$-C_3H_6(OC_3H_6)_y$ (V)
worin y 1 bis 12 ist
oder eine Gruppe der Formel VI

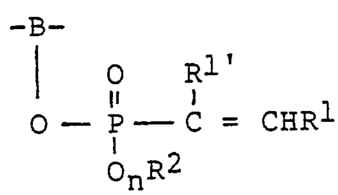 (VI)

worin B für geradkettiges oder verzweigtes $(C_3\text{-}C_{12})$-Alkylen steht und $R^1$, $R^{1'}$, $R^2$ und n wie oben angegeben definiert sind, bedeuten.

2. Durch Strahlung polymerisierbares Gemisch nach Anspruch 1, dadurch gekennzeichnet, daß $R^1$ und $R^{1'}$ Wasserstoff oder Methyl bedeuten.

3. Durch Strahlung polymerisierbares Gemisch nach den Ansprüchen 1 oder 2, dadurch gekennzeichnet, daß $R^2$ Methyl, Ethyl oder Propyl bedeutet.

4. Durch Strahlung polymerisierbares Gemisch nach einem oder mehreren der Ansprüche 1 bis 3, dadurch gekennzeichnet, daß
A für Verbindungen der allgemeinen Formel II steht, in denen m gleich 0, oder
für Verbindungen der allgemeinen Formel IV, in denen x gleich 1 bis 3, oder
für Verbindungen der allgemeinen Formel V, in denen y gleich 1 bis 3 oder

für Verbindungen der allgemeinen Formel VI, in denen B ein geradkettiges ($C_3$-$C_6$)-Alkylen bedeuten.

5. Durch Strahlung polymerisierbares Gemisch nach einem oder mehreren der Ansprüche 1 bis 4, dadurch gekennzeichnet, daß das Bindemittel a) in Wasser oder wäßrig-alkalischen Lösungen löslich ist.

6. Durch Strahlung polymerisierbares Gemisch nach einem oder mehreren der Ansprüche 1 bis 5, dadurch gekennzeichnet, daß der Polymerisationsinitiator c) ge genüber sichtbarem oder langwelligem ultraviolettem Licht empfindlich ist.

7. Durch Strahlung polymerisierbares Gemisch nach einem oder mehreren der Ansprüche 1 bis 6, dadurch gekennzeichnet, daß es 20 bis 95 Gew.-% polymeres Bindemittel a), 5 bis 80 Gew.-% polymerisierbare Verbindung b) und 0,01 bis 10 Gew.-% Polymerisationsinitiator c) enthält.

8. Durch Strahlung polymerisierbares Aufzeichnungsmaterial, im wesentlichen bestehend aus einem Schichtträger und einer darauf aufgebrachten durch Strahlung polymerisierbaren Schicht, dadurch gekennzeichnet, daß die durch Strahlung polymerisierbare Schicht der der Ansprüche 1 bis 7 entspricht.